# EUROPÄISCHE PATENTSCHRIFT

(11) **EP 2 645 375 B1**
(45) Veröffentlichungstag und Bekanntmachung des Hinweises auf die Patenterteilung: **20.02.2019**
(21) Anmeldenummer: 13158054.0
(22) Anmeldetag: 06.03.2013
(51) Int. Cl.: H01B 3/46, C08G 77/24, H01L 41/04

(54) **Dielektrisches Elastomer auf Fluorosilicon-Basis und Verfahren zu seiner Herstellung**
Dielectric elastomer on a fluorosilicone basis and method for producing the same
Elastomère diélectrique à base de fluorosilicone et son procédé de fabrication

(30) Priorität: 12.03.2012 DE 102012203827; 12.07.2012 DE 102012212222
(43) Veröffentlichungstag der Anmeldung: 02.10.2013
(73) Patentinhaber: Fraunhofer-Gesellschaft zur Förderung der angewandten Forschung e.V., 80686 München (DE)
(72) Erfinder: Böse, Holger, 97080 Würzburg (DE); Uhl, Detlev, 97318 Kitzingen (DE); Rabindranath, Raman, Dr., 51147 Köln (DE)
(74) Vertreter: Strehl Schübel-Hopf & Partner

(56) Entgegenhaltungen:
- US-A1- 2005 157 893
- US-A1- 2007 200 467
- SOON MOK HA ET AL: "Interpenetrating networks of elastomers exhibiting 300% electrically-induced area strain", SMART MATERIALS AND STRUCTURES, IOP PUBLISHING LTD., BRISTOL, GB, Bd. 16, Nr. 2, 1. April 2007 (2007-04-01), Seiten S280-S287, XP020120443, ISSN: 0964-1726, DOI: 10.1088/0964-1726/16/2/S12

## Beschreibung

Die vorliegende Erfindung betrifft ein Dielektrisches Elastomer, d.h. eine dehnbare, dielektrische Elastomer-Folie, die beidseitig mit Elektrodenlagen versehen ist. Das Material des erfindungsgemäßen Dielektrischen Elastomeren ist aus oder unter Verwendung von Fluorosilicon-Polymeren aufgebaut und besitzt eine stark verbesserte Aktuationsdehnung.

Dielektrische Elastomere bestehen aus dehnbaren Elastomerfolien, die beidseitig mit ebenfalls dehnbaren Elektroden beschichtet sind. Bei der Dehnung müssen die Elektroden ihre elektrische Leitfähigkeit beibehalten. Solche Dielektrischen Elastomere können als Aktoren, als Sensoren oder auch als Generatoren eingesetzt werden.

Bei der Nutzung als Aktor wird zwischen den Elektroden eine elektrische Spannung angelegt, die dazu führt, dass sich die Elastomerfolie, auch Dielektrikum genannt, in der Dicke durch den elektrostatischen Druck komprimiert und wegen der näherungsweisen Volumenkonstanz gleichzeitig in der Fläche ausdehnt. Im Sensorbetrieb wird die Kapazität des Dielektrischen Elastomers gemessen, das sich wie ein flexibler Kondensator verhält. Beim Dehnen der Folie ändert sich die Kapazität des Kondensators, wodurch Dehnungen, Kräfte oder Drücke bestimmt werden können. Im Betrieb als Generator werden auf die gedehnte Kondensatorfolie elektrische Ladungen übertragen. Nach der Relaxation der gedehnten Folie werden die Ladungen in einem höheren Energiezustand wieder entnommen, woraus sich ein Gewinn an elektrischer Energie ergibt.

Die für die technische Nutzung wesentlichen Eigenschaften des Elastomermaterials sind die Härte bzw. der E-Modul, die elektrische Durchschlagsfeldstärke sowie die dielektrische Permittivität. Der E-Modul sollte für viele Anwendungen sehr niedrig sein, damit z. B. im Aktorbetrieb hohe Aktordehnungen im elektrischen Feld erreicht werden. Die elektrische Durchschlagsfeldstärke sollte möglichst hoch sein, um hohe elektrische Spannungen anlegen und damit die Aktuationskraft und -dehnung steigern zu können. Ebenso hat auch eine hohe dielektrische Permittivität einen positiven Einfluss, da die Aktuationskraft und -dehnung bei gleicher angelegter elektrischer Feldstärke erhöht werden.

Bekannte Elastomermaterialien, die als Dielektrikum von Dielektrischen Elastomeren eingesetzt werden, sind Silicone (vor allem Polydimethylsiloxan), Acrylate, Polyurethane, Fluorpolymere, Polybutadien, Naturkautschuk u. a.. Hinsichtlich der geeigneten Elastizitätsmodule wird für derartige Materialien in US 2007/0200467 A1 ein sehr breiter Bereich von 0,1 bis 10 MPa, vorzugsweise von 0,3 bis 3 MPa vorgeschlagen. Diese Druckschrift erwähnt auch ein käufliches Fluorsilicon, ohne sich mit dessen spezifischem Elastizitätsmodul zu beschäftigen. Aus R. Pelrine et al., Micro Electro Mechanical Systems 1997, S. 238-243 und R. Pelrine et al., Materials Science and Engineering C 11, 89-100 (2000) geht hervor, dass dieses Material einen Young'schen Modul von 0,5 MPa besitzt, allerdings Probleme hinsichtlich der Homogenität des Materials zeigte.

Elektroaktive Polymerfasern zum Einsatz als künstliche Muskeln sind aus US 2009/0085444 A1 bekannt.

Der vorliegenden Erfindung liegt die Aufgabe zugrunde, ein verbessertes Material für das Dielektrikum eines Dielektrischen Elastomer bereitzustellen, das insbesondere eine hohe Permittivität aufweist, und damit eine hohe Aktordehnung ermöglicht.

Fluorsilicone haben im Vergleich zu unfluorierten Siliconen den Vorteil einer deutlich erhöhten dielektrischen Permittivität. Die mechanischen Eigenschaften der bekannten Materialien sind jedoch für den Einsatz in Dielektrischen Elastomeren ungünstig, da das Elastomermaterial relativ hart ist, d. h. einen hohen E-Modul aufweist, wie auch aus Pelrine et al. in Micro Electro Mechanical Systems, a.a.O., ersichtlich. Mit solchen fluorierten Siliconen lassen sich nur wenig effektive Dielektrische Elastomeraktoren herstellen, die keine hohe Aktordehnung erzeugen. Den Erfindern ist es jedoch überraschend gelungen, ein fluoriertes Siliconelastomer aufzufinden, das einerseits fluorierte Alkylgruppen enthält, die zu einer hohen Permittivität beitragen, gleichzeitig aber einen E-Modul von deutlich unter 500kPa im ungedehnten Zustand bei Raumtemperatur besitzt.

Es handelt sich bei diesem Material um ein dreidimensional vernetztes, teilweise oder vollständig fluoriertes Polysiloxan, das trotz der dreidimensionalen Vernetzung in überraschender Weise einen niedrigen E-Modul besitzt. Dieser soll 450 kPa nicht übersteigen; vorzugsweise liegt er deutlich darunter, z.B. unter 400 kPa oder sogar unter 350 kPa.

Das erfindungsgemäße Material lässt sich auf verschiedenen Wegen gewinnen. In einer ersten Ausführungsform der Erfindung wird hierfür ein dreidimensional vernetztes, alkylgruppenhaltiges Polysiloxan, dessen Alkylgruppen zumindest teilweise fluoriert sind, mit einem fluorierten Siliconöl kombiniert. Als fluoriertes Siliconöl eignet sich vor allem ein niederviskoses, in der Regel lineares Oligo- oder Polysiloxan mit Alkylgruppen, die teilweise oder vollständig fluoriert sind. In einer zweiten Ausführungsform der Erfindung wird ein dreidimensional vernetztes, dabei aber besonders weitmaschiges alkylgruppenhaltiges Polysiloxan bereitgestellt, dessen Alkylgruppen zumindest teilweise fluoriert sind.

Es ist für jede der beiden Ausführungsformen bevorzugt, dass die Vernetzung der jeweiligen Polysiloxane mit Hilfe einer Additionsreaktion erfolgte, bei der SiH-Gruppen mit C=C-Doppelbindungen in über Kohlenstoff an Silicium gebundenen Resten, beispielsweise von Allyl- oder Vinylsilanen, reagierten. Die Vorteile liegen hierbei darin, dass zum einen bei der Umsetzung keine niedermolekularen Nebenprodukte entstehen, wie es bei einer Kondensationsreaktion der Fall wäre, und dass zum anderen die durch eine solche Additionsvernetzung erzeugten Siloxane keiner oder nur einer äußerst geringen Schrumpfung unterliegen.

In einer besonderen Ausführungsform der Erfindung werden beide Varianten miteinander kombiniert derart, dass ein besonders weitmaschig vernetztes Polysiloxan mit einem Siliconöl kombiniert wird.

In der ersten Ausführungsform der Erfindung ist es ist bevorzugt, wenn die dreidimensionale Vernetzung des Vorläufermaterials für das vernetzte Polyalkylsiloxan in Gegenwart des Siliconöls erfolgt. Durch diese Maßnahmen wird das Entstehen eines homogenen Materials begünstigt.

In der zweiten Ausführungsform der Erfindung wird die Weitmaschigkeit des Polysiloxans dadurch bewirkt, dass besonders lange Polysiloxanketten erzeugt werden, was weiter unten näher erläutert werden wird.

Das dreidimensional vernetzte, teilweise oder vollständig fluorierte Polysiloxan weist in allen Fällen vorzugsweise lange Ketten auf, insbesondere mit der Baueinheit -Si(W)(W')-O-, worin W und W' gleich oder verschieden sind, W ein mindestens teilweise fluoriertes, kurz- bis längerkettiges Alkyl (z.B. C₁₋C₁₀-Alkyl) bedeutet und W' entweder dieselbe Bedeutung wie W hat oder ein unfluoriertes kurz- bis längerkettiges Alkyl (z.B. C₁-C₁₀-Alkyl) ist. Die genannten, vorzugsweise langen Ketten können mit Ausnahme der Endgruppen aus dieser Baueinheit bestehen; alternativ weisen sie die Baueinheit in einem Anteil von mindestens 50 %, vorzugsweise von mindestens 90 % (bezogen auf die Anzahl von Baueinheiten mit jeweils einem Si-Atom) auf. Vorzugsweise beide Enden der Ketten (in spezifischen Fällen darüber hinaus auch weitere Stellen im Molekül, was aber wegen der wünschenswerten Weichheit des Produkts nur in seltenen Fällen realisiert werden sollte,) sind über Verknüpfungsgruppen derart an weitere Silan- oder Siloxaneinheiten angebunden, dass ein dreidimensionales Netzwerk gebildet wird. Besonders bevorzugt handelt es sich dabei um ggf. alkylierte Ethylengruppen. Diese sind hervorgegangen aus C=C-doppelbindungshaltigen Endgruppen (bzw. ggf. zusätzlichen C=C-doppelbindungshaltigen Gruppen) der entsprechenden langen Ketten, beispielsweise Vinyl- oder Allylgruppen, die z.B. mit Si-H-Gruppen der weiteren Silan- oder Siloxaneinheiten reagiert haben. Diese "klassische" Silicongummi-Reaktion ist auch deshalb besonders bevorzugt, weil dabei ausschließlich Alkylengruppen entstehen; stattdessen können für die erwähnte Vernetzung auch andere Kupplungs- oder Additionspolymerisationsreaktionen verwendet werden, die dem Fachmann bekannt sind.

Von den für diese Vernetzungsreaktionen als Ausgangsmaterialien verwendeten Siloxanen besitzt in bevorzugter Weise mindestens eines ein Molekulargewicht von mindestens 10000 g/mol, stärker bevorzugt von mindestens 20000 g/mol und besonders bevorzugt von mindestens 40000 g/mol, damit bei der Reaktion die langen Ketten des dreidimensional vernetzten Polysiloxans entstehen können. In einer günstigen Ausführungsform der Erfindung handelt es sich bei diesem Siloxan um ein kettenförmiges Molekül mit den oben beschriebenen Endgruppen. Dieses wird auch als "langkettiges Polysiloxan" bezeichnet.

Um die genannten linearen Polysiloxanketten zu vernetzen, wird ein Silan oder Siloxan eingesetzt, das mehr als zwei, vorzugsweise drei reaktive Gruppen trägt, die mit den Endgruppen des kettenförmigen Moleküls reagieren können. Günstig sind hierfür die oben genannten Si-H-Gruppen. Das Vernetzungsmittel kann wie das kettenförmige Polysiloxan Baueinheiten -Si(W)(W')-O- aufweisen, worin W und W' dieselbe Bedeutung wie oben angegeben besitzen. Ein anderes Beispiel für ein derartiges Vernetzungsmittel ist ein Tris(dialkylsiloxy)silan, beispielsweise ein Tris(dimethylsiloxy)silan, das seinerseits vorzugsweise teilweise oder vollständig fluoriert ist. Ein konkretes Beispiel hierfür ist Trifluoropropyltris(dimethylsiloxy)silan. In spezifischen Fällen kann das Vernetzungsmittel auch noch mehr als drei, nämlich beispielsweise vier reaktive Gruppen tragen; dies wird jedoch wegen des Ziels, ein möglichst weiches Material zu erzeugen, die Ausnahme sein.

Um ein besonders weitmaschiges Polysiloxan zu erzeugen, können die Ketten des vorzugsweise bereits langkettigen Polysiloxans weiter verlängert sein, und zwar z.B. dadurch, dass sie mit einem Silan oder Siloxan umgesetzt wurden, das eine oder zwei, vorzugsweise zwei reaktive Gruppen trägt, die mit den Endgruppen des kettenförmigen Moleküls reagieren können. Günstig sind hierfür wiederum Si-H-Gruppen. Das Verlängerungsmittel kann wie das kettenförmige Polysiloxan Baueinheiten -Si(W)(W')-O- aufweisen, worin W und W' dieselbe Bedeutung wie oben angegeben besitzen. Ein anderes Beispiel für ein derartiges Verlängerungsmittel ist ein Bis(dialkylsiloxy)silan, beispielsweise ein Bis(dimethylsiloxy)silan, das seinerseits vorzugsweise teilweise oder vollständig fluoriert ist. Ein konkretes Beispiel hierfür ist Trifluoropropylbis(dimethylsiloxy)silan.

Je nach vorgesehener Vernetzungs-/Verlängerungsreaktion kann bzw. muss der Mischung der Ausgangsmaterialien ein geeigneter Katalysator zugegeben werden. Im Falle der Vernetzung durch Reaktion von Vinylgruppen mit S-H-Gruppen ist dies in der Regel ein platinhaltiges Material, z.B. der sog. Karstedt-Katalysator, der eine Vernetzung bei Raumtemperatur ermöglicht und im Handel erhältlich ist.

Wenn die Ketten des dreidimensional vernetzten, teilweise oder vollständig fluorierten Polysiloxans nicht ausschließlich aus Baueinheiten -Si(W)(W')-O- aufgebaut sind, können sie z.B. weiterhin Baueinheiten Si(W")₂-O- aufweisen, in denen W" eine unfluorierte Alkylgruppe mit z.B. C₁-C₁₀-Alkyl bedeutet. Auch gemischte Baueinheiten Si(W)(W')-O-, in denen W' eine unfluorierte Alkylgruppe ist, sind möglich. Die Verteilung der unterschiedlichen Substituenten kann einem regelmäßigen Muster folgen; in der Regel ist sie statistisch.

Als teilweise fluorierte Gruppen kommen beispielsweise Trifluorpropyl- und längerkettige Gruppen wie Trifluoroctylgruppen in Betracht, wobei Trifluorpropylgruppen bevorzugt sind; als vollständig fluorierte Gruppen kommen beispielsweise Trifluormethylgruppen in Betracht. Als unfluorierte Alkylgruppen sind Methyl-, Propyl- und Octylgruppen bevorzugt. Die jeweilige Wahl der Gruppen kann dem Fachmann überlassen bleiben, sofern sichergestellt ist, dass ein ausreichender Fluoranteil im Material vorhanden ist. Hierfür ist es hilfreich, wenn mindestens 10%, vorzugsweise mindestens 20% und besonders bevorzugt mindestens 40% der Seitenketten in der Baueinheit die obige Bedeutung von W besitzen, die ja in der Regel mindestens eine CF₃-Gruppe und ggf. zusätzliche CF₂-Gruppen aufweisen. Vergleichbares gilt für die Kettenverlängerungs- und Vernetzungsmittel.

Die Moleküle des Siliconöls umfassen Oligo- oder Polyalkylsiloxane mit Baueinheiten -Si(W)(W')-O-, ggf. in Kombination mit Baueinheiten -Si(W")₂-O wie oben definiert. Vorzugsweise besteht ihre Kette aus den Baueinheiten -Si(W)(W')-O-; jedoch besitzen sie in der Regel keine reaktiven Endgruppen. Ihre Endgruppen können stattdessen ggf. teilweise oder vollständig fluorierte Alkylgruppen wie oben für den Substituenten W' angegeben oder unfluorierte Alkylgruppen wie oben für W" definiert sein. Bevorzugt ist es, wenn das kettenförmige Polysiloxan und das Siliconöl in etwa den gleichen Fluorierungsgrad aufweisen, weil dann die Kompatibilität zwischen diesen Materialien besonders gut ist, was die Herstellung einer homogenen Mischung begünstigt, und sie außerdem in etwa die gleiche dielektrische Permittivität aufweisen.

Die Oligo- und/oder Polyalkylsiloxane des Siliconöls beistzen ein Molekulargewicht von mindestens etwa 500 g/mol, vorzugsweise von mindestens 750 g/mol und am meisten bevorzugt von höchstens etwa 1500 g/mol. Aufgrund des geringen Molekulargewichts ist das Siliconöl flüssig bis pastös; vorzugsweise besitzt es eine Viskosität von 50 bis 150 mm²/s (50 bis 150 cSt), besonders bevorzugt von 80 bis 120 mm²/s auf.

Die Massenverhältnisse von fluoriertem, dreidimensional vernetztem Polysiloxan zu ebenfalls fluoriertem Siliconöl liegen im fluorierten Siliconelastomer bevorzugt bei ca. 10:1 bis 1:5, stärker bevorzugt bei ca. 5:1 bis ca. 1:1. Je weiter die Maschen des dreidimensional vernetzten Polysiloxans sind, desto weniger Siliconöl wird benötigt, das gegebenenfalls - in der oben beschriebenen zweiten Ausführungsform - ganz weggelassen werden kann.

In einer besonderen Ausführungsform der Erfindung, die mit jeder anderen Ausführungsform kombiniert werden kann, enthält das fluorierte Siliconelastomer einen Füllstoff. Dieser ist vorzugsweise ausgewählt unter elektrisch polarisierbaren Partikeln wie Bariumtitanat, Bleizirkonattitanat oder Titandioxid und/oder elektrisch leitfähigen Partikeln aus Kohlenstoff wie Graphit, Graphen oder Carbon Nanotubes und/oder Metallen wie Eisen, Kupfer, Silber oder Gold und/oder leitfähigen Polymeren wie Polyanilin, Polyacetylen, Polypyrrol, Polyparaphenylen oder Polythiophen und ist zur Erhöhung der Permittivität vorgesehen. Unter den vorgenannten Stoffen sind elektrisch polarisierbaren Partikel bevorzugt; wenn leitfähige Partikel oder leitfähige Polymere verwendet werden sollen, ist darauf zu achten, dass sie in einer ausreichend geringen Konzentration derart enthalten sind, dass sie ohne Berührung untereinander in dem Siliconelastomeren eingebettet sind, um jede Möglichkeit eines Kurzschlusses zwischen den beidseitigen Elektrodenfolien zu vermeiden. Stattdessen oder zusätzlich können insbesondere die elektrisch leitfähigen Partikel mit einer isolierenden Beschichtung versehen sein.

Die Erfindung stellt in überraschender Weise ein homogenes Material als Ausgangsmaterial für das Dielektrische Elastomer bereit, obwohl sich nahezu keine anderen Flüssigkeiten mit den chemischen Vorstufen von fluoriertem Siliconelastomer mischen lassen. Durch die Fluorierung steigt die dielektrische Permittivität gegenüber unfluoriertem Siliconelastomer. Durch die Zugabe von fluoriertem Siliconöl bzw. die Bereitstellung weiter Maschen wird das fluorierte Siliconelastomer weicher. Beide Effekte zusammen führen zu einer deutlichen Verbesserung der Eigenschaften des Dielektrischen Elastomers. Die Verbesserung äußert sich in einer erhöhten Aktorkraft und in einer erhöhten Aktuationsdehnung von Dielektrischen Elastomeraktoren.

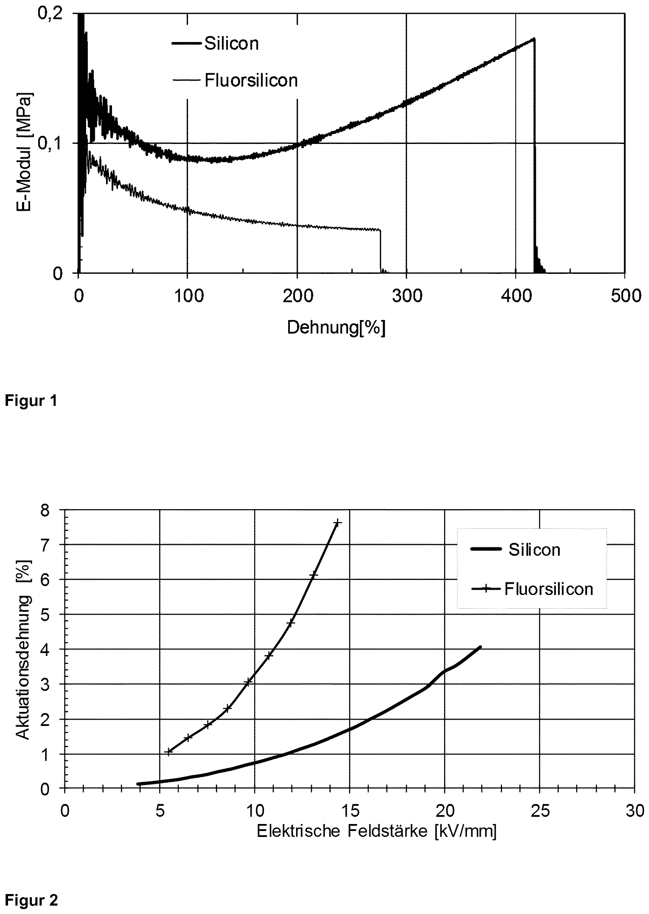

Die Dielektrischen Elastomere aus fluorierten Siliconelastomeren der vorliegenden Erfindung weisen eine gegenüber unfluorierten Siliconelastomeren deutlich erhöhte dielektrische Permittivität auf. Durch den Zusatz von fluoriertem Siliconöl bzw. die Maschenvergrößerung lässt sich der E-Modul stark absenken. Er besitzt einen Wert von höchstens 450 kPa, vorzugsweise von höchstens 300 MPa, stärker bevorzugt von höchstens 200 kPa und besonders bevorzugt von höchstens 100 kPa bei einer Dehnung von 100%, d. h. das Material wird sehr weich. Gleichzeitig dehnt es sich aktuatorisch bei wesentlich geringeren Feldstärken. Damit lassen sich Dielektrische Elastomeraktoren herstellen, die gegenüber solchen aus unfluoriertem Silcionelastomer eine stark erhöhte Aktuationsdehnung aufweisen. Entsprechende Vorteile sind auch für Dielektrische Elastomersensoren (höhere Empfindlichkeit) und für Dielektrische Elastomergeneratoren (höhere Energiedichte) gegeben. Diese Eigenschaften lassen sich aus den Figuren ersehen: Figur 1 zeigt den E-Modul eines unfluorierten im Vergleich zu einem fluorierten Siliconelastomer. Der E-Modul des fluorierten Siliconelastomers ist deutlich kleiner. Figur 2 zeigt die Aktuationsdehnung eines unfluorierten im Vergleich zu einem fluorierten Siliconelastomer. Die Aktuationsdehnung des fluorierten Siliconelastomers ist deutlich größer.

Das voranstehend beschriebene fluorierte Siliconelastomer wird zur Herstellung eines Dielektrischen Elastomers in die Form eines Films (des Dielektrikums) gebracht (z.B. gesprüht oder gerakelt), beispielsweise durch Aufbringen der noch unvernetzten Mischung der Ausgangsmaterialien, ggf. in Gegenwart des erforderlichen Katalysators, auf eine Folie mit schlechten Haftungseigenschaften, und sodann vernetzt, z.B. durch Erwärmen. Die Bedingungen sollten vorzugsweise so gewählt werden, dass der Film nach dem Vernetzen eine Dicke von unter 1 mm, stärker bevorzugt von unter 500 µm und besonders bevorzugt von unter 250 µm aufweist.

Zur Herstellung des Dielektrischen Elastomeren wird dieser Film von seiner Unterlage abgezogen und beidseitig mit einer Elektrodenschicht versehen. Diese weist vorzugsweise leitfähige Partikel aus Kohlenstoff (z.B. Graphit, Graphen, Kohlenstoffnanoröhren) und/oder Metallen (z.B. Aluminium, Eisen, Kupfer, Silber, Gold) auf, die vorzugsweise mit Hilfe eines Binders miteinander verklebt sind, der in günstiger Weise auch gut an dem Siliconelastomer-Film haftet. Statt dessen können die Elektrodenschichten auch aus oder mit einem leitfähigen Polymeren wie Polyanilin, Polyacetylen, Polypyrrol, Polyparaphenylen, PEDOT:PPS (d.i. Poly-3,4-ethylendioxythiophen:-Polystyrolsulfonat, ein dotiertes, leitfähiges, konjugiertes Polymer, dessen Thiophengruppen teilweise eine positive Ladung tragen, welche durch das polymere Gegenion PSS kompensiert werden) oder Polythiophen hergestellt sein.

In einer besonders bevorzugten Ausführungsform besitzen die leitfähigen Partikel der Elektrodenschicht eine anisotrope Form und bestehen aus Metall oder weisen eine metallische Beschichtung auf. Durch die anisotrope Form der leitfähigen Partikel lassen sich bereits mit relativ geringen Volumengehalten hohe Leitfähigkeiten erzielen. Außerdem geht der Kontakt zwischen den Partikeln bei einer Dehnung der Elektrodenschicht nicht so leicht verloren. Die Form der Partikel kann dabei beliebig gewählt werden, beispielsweise unter Flakes (regelmäßigen oder unregelmäßigen Plättchen, deren Durchmesser in der x-y-Ebene größer ist als in z-Richtung), regelmäßigen oder unregelmäßigen Stäbchen oder Fasern.

Als Kern von beschichteten Partikeln können dem Grunde nach beliebige Materialien verwendet werden. Günstig sind nichtleitende anorganische Materialien wie z.B. Glas; es sind aber auch organische Materialien (insbesondere Kunststoffe) oder Metalle einsetzbar. In einer spezifischen Ausführungsform werden silberbeschichtete Flakes mit einem Kern aus Glas oder aus Kupfer eingesetzt.

Die Erfindung stellt auch ein Multischichtsystem bereit, umfassend ein Dielektrisches Elastomer wie voranstehend beschrieben, wobei mindestens auf einer der Beschichtungen aus einem dehnbaren Elektrodenmaterial eine oder mehrere Doppelschicht(en) aufgebracht ist/sind, die aus einer weiteren Schicht aus dem fluorierten Siliconelastomer mit einem E-Modul von maximal 450 MPa und einer weiteren Beschichtung aus einem dehnbaren Elektrodenmaterial besteht, derart, dass jeweils zwei Beschichtungen aus einem dehnbaren Elektrodenmaterial durch eine Schicht aus einem fluorierten Siliconelastomer voneinander getrennt sind und umgekehrt, wobei die Beschichtungen aus einem dehnbaren Elektrodenmaterial alternierend als positive und als negative Elektrode geschaltet werden können oder geschaltet sind. Durch diese Anordnung können die beschriebenen Wirkungen wesentlich verstärkt bzw. vervielfacht werden.

Die Elektrodenschichten können ggf. jeweils mit einer Schicht aus einem Isolatormaterial abgedeckt sein, um das Hantieren mit dem Dielektrischen Elastomer sicher zu machen.

In einer bevorzugten Ausführungsform der Erfindung werden die Elektrodenschichten unter Verwendung ebenfalls eines mindestens teilweise fluorierten Siliconelastomeren hergestellt, wobei ganz besonders bevorzugt jeweils dasselbe oder ein sehr ähnliches Material verwendet wird, wie es auch für das zwischen den Elektroden befindliche Dielektrikum eingesetzt wird. Dieses kann mit den oben genannten leitfähigen Partikeln wie Kohlenstoff- oder Metallpartikeln befüllt sein. Der Anteil an leitfähigen Partikeln liegt dabei vorzugsweise zwischen 20 und 70 M.-%, vorzugsweise zwischen 25 und 65 M.-% Diese Ausführungsform ist deshalb besonders günstig, weil die Verwendung eines ähnlichen oder identischen Siliconelastomeren für sowohl den dielektrischen Film als auch die beidseitigen Elektroden bewirkt, dass die Dehnbarkeit der Materialien vergleichbar ist. Außerdem haften derartige Elektrodenschichten besonders gut auf dem Dielektrikum, da ihr Material vor dem Vernetzen Gruppen trägt, die mit dem Dielektrikum reagieren können.
Mögliche Anwendungen der Erfindung sind:
- Dielektrische Elastomeraktoren, z. B. als lineare Stellantriebe für Spiegel oder Klappen, für Pumpenantriebe oder für haptische Bedienoberflächen
- Dielektrische Elastomersensoren, z. B. als Dehnungssensoren, als Kraft- oder Drucksensoren
- Dielektrische Elastomergeneratoren, z. B. zur mobilen Energieerzeugung.

Nachstehend soll die Erfindung anhand eines Ausführungsbeispiels näher erläutert werden.

### Ausführungsbeispiele:

### Materialbeispiel 1

49,71 g eines fluoriertes Divinyl(polysiloxan)-Copolymeren, dessen Siliciumatome teils Trifluorpropyl- und teils Methylgruppen tragen, wurden mit 0,24 g Trifluoropropyltris(dimethylsiloxy)silan und 45 g fluoriertem Siliconöl, dessen Siliciumatome ebenfalls teils Trifluorpropyl- und teils Methylgruppen tragen und das eine Viskosität im Bereich von ca. 100 mm²/s aufwies, in Gegenwart von Karstedt-Katalysator mit Hilfe eines Zentrifugalmischers vermischt. Zur Herstellung einer Elastomerfolie mit definierter Schichtdicke wurde aus dieser fluorierten Siliconmischung mit Hilfe eines Spaltrakels auf einer ebenen Unterlage ein gleichmäßiger Film gezogen. Durch Beheizen mit einem Infrarotstrahler wurde der Siliconfilm vernetzt. Der E-Modul des erhaltenen Films wurde durch eine Zug-Dehnungs-Messung ermittelt; er ist aus Fig. 1 ersichtlich (Kurve "Fluorsilicon"). Bei Beginn der Messung lag er bei etwa 100 kPa und bei einer Dehnung von 100% bei ca. 50 kPa. Zur Ermittlung des E-Moduls wurden Probenkörper (0,25 x 10 x 50) mm aus einer gerakelten Folie ausgeschnitten und mit Hilfe der Zugprüfungsmaschine Zwicki 1120 der Firma Zwick vermessen. Die Zugprüfung erfolgte dabei mit einer Zuggeschwindigkeit von 120 mm/min. Die in der vorliegenden Anmeldung angegebenen E-Module sind im Zweifelsfall jeweils auf eine Messung wie hier beschrieben zu beziehen und zwar vorzugsweise auf den bei 100% Dehnung erhaltenen Wert.

### Materialbeispiel 2

Beispiel 1 wurde wiederholt mit der Maßgabe, dass anstelle von 45 g fluoriertem Siliconöl Trifluorpropylbis(dimethylsiloxy)silan in einer zum Divinyl(polysiloxan)-Copolymeren äquimolaren Menge eingesetzt wurde.

### Materialbeispiel 3

Beispiel 1 wurde wiederholt mit der Maßgabe, dass zusätzlich zum fluorierten Siliconöl Trifluorpropylbis(dimethylsiloxy)silan in einer zum Divinyl(polysiloxan)-Copolymeren äquimolaren Menge eingesetzt wurde.

### Beispiele 1 bis 3

Zur Herstellung eines Dielektrischen Elastomeraktors wurde die jeweilige die Elastomerfolie beidseitig mit flexiblen Elektroden beschichtet. Als Elektrodenmaterial diente dabei eine Mischung von 75 M.% des oben dargestellten Fluorsiliconelastomers mit 25 M.% Graphitpartikeln. Die Elastomerbeschichtung erfolgte mittels Airbrush-Pistole.

Die Aktuationsdehnung eines Elastomeraktors mit dem Material des Beispiels 1 bei verschiedenen Feldstärken ist der Figur 2 zu entnehmen (Kurve "Fluorsilicon").

Die vorliegend verwendete Abkürzung "M.-%" bedeutet Masse-%.

Zusammengefasst betrifft die Erfindung die folgenden, teils grundlegenden, teils bevorzugten Ausführungsformen:
A. Ein Dielektrisches Elastomer, umfassend eine Folie, die ein fluoriertes Siliconelastomer enthält oder daraus besteht, sowie beidseitig der Folie eine Beschichtung aus einem dehnbaren Elektrodenmaterial, oder bestehend aus diesen Komponenten, dadurch gekennzeichnet, dass das fluorierte Siliconelastomer einen E-Modul von maximal 450 kPa besitzt.
B. Ein Dielektrisches Elastomer wie unter A definiert, dadurch gekennzeichnet, dass das fluorierte Siliconelastomer ein dreidimensional vernetztes fluoriertes, alkylgruppenhaltiges Polysiloxan in Kombination mit einem fluorierten Siliconöl aufweist und/oder dass das fluorierte Siliconelastomer ein dreidimensional weitmaschig vernetztes, fluoriertes, alkylgruppenhaltiges Polysiloxan aufweist, dessen Weitmaschigkeit durch eine Kettenverlängerung durch Addition eines zwei Si-H-Gruppen enthaltenden kettenförmigen Siliconmoleküls an ein Alkenylgruppen, insbsondere Vinylgruppen enthaltendes Polysiloxanmolekül bewirkt wurde.
C. Ein Dielektrisches Elastomer wie unter B definiert, worin das Siliconöl eine Viskosität im Bereich von nicht mehr als 150 mm²/s besitzt.
D. Ein Dielektrisches Elastomer wie unter B oder C definiert, wobei der Anteil des fluorierten Siliconöls im fluorierten Siliconelastomer mindestens 10 Masse-%, bevorzugt mindestens 25 Masse-% und besonders bevorzugt mindestens 40 Masse-% beträgt.
E. Ein Dielektrisches Elastomer wie unter B, C oder D definiert, wobei der Fluorierungsgrad des fluorierten Siliconöls dem des dreidimensional vernetzten, fluorierten, alkylgruppenhaltigen Polysiloxans entspricht oder um maximal ±10% davon abweicht, bezogen auf die Anzahl von fluorierten Alkylgruppen in den jeweiligen Materialien.
F. Ein Dielektrisches Elastomer wie zuvor in einem der Punkte A bis E definiert, wobei das fluorierte Siliconelastomer durch die Umsetzung eines langkettigen fluorierten Dialkenyl(polysiloxan)-Copolymeren mit zwei oder mehr als zwei reaktiven Gruppen mit einem fluorierten silanhaltigen Vernetzer hergestellt worden ist, der drei oder mehr als drei reaktive Gruppen aufweist, oder wobei das fluorierte Siliconelastomer durch die Umsetzung eines langkettigen fluorierten Dialkenyl(polysiloxan)-Copolymeren mit drei oder mehr als drei reaktiven Gruppen mit einem fluorierten Siloxan hergestellt worden ist, das zwei oder mehr als zwei reaktive Gruppen aufweist.
F'. Ein Dielektrisches Elastomer wie in Punkt F definiert, worin die Alkenylgruppen ausgewählt sind unter Vinyl- und Allylgruppen und insbesondere Vinylgruppen sind.
G. Ein Dielektrisches Elastomer wie unter F oder F' definiert, worin das langkettige fluorierte Dialkenyl- bzw. Divinyl(polysiloxan)-Copolymer nicht mehr als zwei reaktive Gruppen trägt und der fluorierte silanhaltige Vernetzer nicht mehr als drei reaktive Gruppen trägt, oder worin das langkettige fluorierte Dialkenyl- bzw. Divinyl(polysiloxan)-Copolymer nicht mehr als drei reaktive Gruppen trägt und das fluorierte Siloxan nicht mehr als zwei reaktive Gruppen trägt.
H. Ein Dielektrisches Elastomer wie unter B, F oder G definiert, wobei das Alkenyl- bzw. Vinylgruppen enthaltende Polysiloxanmolekül ein langkettiges fluoriertes Divinyl(polysiloxan)-Copolymer mit einem Molekulargewicht von mindestens 10000 g/mol, bevorzugt mindestens 20000 g/mol und besonders bevorzugt mindestens 40000 g/mol ist.
I. Ein Dielektrisches Elastomer wie unter F bis H definiert, wobei der Fluorierungsgrad des langkettigen fluorierten Dialkenyl- bzw. Divinyl(polysiloxan)-Copolymers mindestens 10 % bevorzugt mindestens 20 % und besonders bevorzugt mindestens 40 % beträgt, und/oder worin 10, 20 bzw. 40 % der Kohlenwasserstoff-Seitengruppen an den Si-Atomen fluoriert sind.
J. Ein Dielektrisches Elastomer wie zuvor in einem der Punkte A bis I definiert, wobei das fluorierte Siliconelastomer Trifluorpropylgruppen und/oder Tridecafluorooctylgruppen enthält.
K. Ein Dielektrisches Elastomer wie zuvor in einem der Punkte A bis J definiert, wobei das fluorierte Elastomer durch die Vernetzung eines fluorierten Divinyl(polysiloxan)-Copolymers mit Trifluoropropyltris(dimethylsiloxy)silan, ggf. unter Verlängerung der Polymerketten durch Zusatz von Difluoropropylbis(dimethylsiloxy)silan, entstanden ist.
L. Ein Dielektrisches Elastomer wie zuvor in einem der Punkte A bis K definiert, wobei der E-Modul des fluorierten Siliconelastomers höchstens 300 kPa, bevorzugt höchstens 200 kPa und besonders bevorzugt höchstens 100 kPa beträgt.
M. Ein Dielektrisches Elastomer wie zuvor in einem der Punkte A bis L definiert, wobei das fluorierte Siliconelastomer elektrisch polarisierbare Partikel, vorzugsweise aus Bariumtitanat, Bleizirkonattitanat oder Titandioxid und/oder elektrisch leitfähige Partikel aus Kohlenstoff, vorzugsweise Graphit, Graphen oder Carbon Nanotubes, Metalle, vorzugsweise Aluminium, Eisen, Kupfer, Silber oder Gold, oder ein leitfähiges Polymer, vorzugsweise Polyanilin, Polyacetylen, Polypyrrol, Polyparaphenylen oder Polythiophen, enthält, wobei die elektrisch leitfähigen Partikel mit einer isolierenden Beschichtung versehen sein können.
N. Ein Dielektrisches Elastomer wie zuvor in einem der Punkte A bis M definiert, wobei die Elastomerfolie eine Dicke von unter 1 mm, bevorzugt unter 500 µm, besonders bevorzugt unter 250 µm aufweist und/oder die Elektroden eine Dicke von unter 100 µm, bevorzugt unter 50 µm, besonders bevorzugt unter 25 µm aufweisen.
O. Ein Dielektrisches Elastomer wie zuvor in einem der Punkte A bis N definiert, wobei die beidseitigen Beschichtungen aus einem dehnbaren Elektrodenmaterial leitfähige Partikel aus Kohlenstoff, vorzugsweise Graphit, Graphen oder Carbon Nanotubes, Metall, vorzugsweise Aluminium, Eisen, Kupfer, Silber oder Gold, oder ein leitfähiges Polymer, vorzugsweise Polyanilin, Polyacetylen, Polypyrrol, Polyparaphenylen, PEDOT:PSS oder Polythiophen enthalten, die in eine organische Matrix aus identischem oder aus unterschiedlichem Material eingebettet sind.
P. Ein Multischichtsystem, umfassend ein Dielektrisches Elastomer wie zuvor in einem der Punkte A bis O definiert, dadurch gekennzeichnet, dass mindestens auf einer der Beschichtungen aus einem dehnbaren Elektrodenmaterial eine oder mehrere Doppelschicht(en) aufgebracht ist/sind, die aus einer weiteren Schicht aus einem fluorierten Siliconelastomer mit einem E-Modul von maximal 450 kPa und einer weiteren Beschichtung aus einem dehnbaren Elektrodenmaterial besteht, derart, dass jeweils zwei Beschichtungen aus einem dehnbaren Elektrodenmaterial durch eine Schicht aus einem fluorierten Siliconelastomer voneinander getrennt sind und umgekehrt, wobei die Beschichtungen aus einem dehnbaren Elektrodenmaterial alternierend als positive und als negative Elektrode geschaltet werden können oder geschaltet sind.
Q. Ein Dielektrisches Elastomer wie zuvor in einem der Punkte A bis O definiert, oder ein Multischichtsystem wie unter P definiert, weiterhin umfassend eine Isolationsschicht auf jeder der außenliegenden Beschichtungen aus einem dehnbaren Elektrodenmaterial.
R. Ein Dielektrisches Elastomer wie zuvor in einem der Punkte A bis O und Q definiert, oder ein Multischichtsystem wie unter P oder Q definiert, worin jede Beschichtung aus einem Elektrodenmaterial mit einer elektrischen Zuleitung kontaktiert ist.
S. Die Verwendung eines Dielektrischen Elastomers oder eines Multischichtsystems wie unter R. definiert als Dielektrischer Elastomeraktor, Dielektrischer Elastomersensor oder Dielektrischer Elastomergenerator.
   i. Ein Verfahren zum Herstellen eines Dielektrischen Elastomeren wie zuvor in einem der Punkte A bis O definiert, umfassend die folgenden Schritte:
      (a) Bereitstellen eines zumindest teilweise fluorierten Polysiloxans, das mindestens zwei reaktive Gruppen trägt,
      (b) Bereitstellen eines mindestens teilweise fluorierierten Silans oder Polysiloxans, das mindestens drei Gruppen trägt, die mit einer reaktiven Gruppe des zumindest teilweise fluorierten Polysiloxans gemäß (a) reagieren können,
         - mit der Maßgabe, dass entweder das mindestens zwei reaktive Gruppen tragende Polysiloxan gemäß (a) oder das mindestens drei reaktionsfähige Gruppen tragende Silan oder Polysiloxan gemäß (b) ein Molekulargewicht von mindestens 10000 g/mol aufweist,
      (c) Vermischen des Polysiloxans gemäß (a), des Silans oder Polysiloxans gemäß (b), eines Siliconöls sowie ggf. eines Katalysators,
      (d) schichtförmiges Auftragen der gemäß (c) entstandenen Mischung auf einer Unterlage,
      (e) Bewirken der Umsetzung der reaktiven Gruppen in der Mischung durch Licht und/oder Wärme und/oder den Zusatz eines Katalysators, unter Ausbilden einer stabilen Folie;
      (f) Ablösen der Folie von der Unterlage,
      (g) Herstellen einer oder mehrerer Mischungen, umfassend die in (c) genannten Materialien sowie ein elektrisch leitfähiges Pulver,
      (h) Auftragen einer Mischung gemäß (g) auf einer Seite der Folie und entweder derselben Mischung oder einer anderen Mischung gemäß (g) auf der anderen Seite der Folie, und
      (i) Bewirken der Umsetzung der reaktiven Gruppen in der Mischung durch Licht und/oder Wärme und/oder den Zusatz eines Katalysators.
   ii. Ein Verfahren zum Herstellen eines Dielektrischen Elastomeren zuvor unter einem der Punkte A bis O definiert, umfassend die folgenden Schritte:
      (a) Bereitstellen eines zumindest teilweise fluorierten Polysiloxans, das mindestens zwei reaktive Gruppen trägt,
      (b) Bereitstellen eines mindestens teilweise fluorierten Silans oder Polysiloxans, das drei oder mehr als drei Gruppen trägt, die mit einer reaktiven Gruppe des zumindest teilweise fluorierten Polysiloxans gemäß (a) reagieren können,
      (c) Bereitstellen eines mindestens teilweise fluorierten Silans oder Polysiloxans, das nicht mehr als zwei Gruppen trägt, die mit einer reaktiven Gruppe des zumindest teilweise fluorierten Polysiloxans gemäß (a) reagieren können,
         - mit der Maßgabe, dass mindestens ein Polysiloxan gemäß (a), (b) oder (c) bereitgestellt wird, das ein Molekulargewicht von mindestens 10000g/mol aufweist,
      (d) Vermischen des Polysiloxans gemäß (a), des Silans oder Polysiloxans gemäß (b), des Silans oder Polysiloxans gemäß (c) sowie ggf. eines Katalysators,
      (e) schichtförmiges Auftragen der gemäß (d) entstandenen Mischung auf einer Unterlage,
      (f) Bewirken der Umsetzung der reaktiven Gruppen in der Mischung durch Licht und/oder Wärme und/oder den Zusatz eines Katalysators, unter Ausbilden einer stabilen Folie,
      (g) Ablösen der Folie von der Unterlage,
      (h) Herstellen einer oder mehrerer Mischungen, umfassend die in (d) genannten Materialien sowie ein elektrisch leitfähiges Pulver,
      (i) Auftragen einer Mischung gemäß (h) auf einer Seite der Folie und entweder derselben Mischung oder einer anderen Mischung gemäß (h) auf der anderen Seite der Folie, und
      (k) Bewirken der Umsetzung der reaktiven Gruppen in der Mischung durch Licht und/oder Wärme und/oder den Zusatz eines Katalysators.
   iii. Ein Verfahren wie unter i. oben angegeben, worin in Schritt (c) zusätzlich ein mindestens teilweise fluoriertes Silan oder Siloxan zugesetzt wird, das nicht mehr als zwei Gruppen trägt, die mit einer reaktiven Gruppe des zumindest teilweise fluorierten Polysiloxans gemäß (a) reagieren können.
   iv. Ein Verfahren wie unter ii. oben angegeben, worin in Schritt (d) zusätzlich ein Siliconöl zugesetzt wird.
   v. Ein Verfahren wie unter einem der Punkte i. bis iv. oben angegeben, worin die mindestens zwei reaktiven Gruppen des zumindest teilweise fluorierten Polysiloxans gemäß (a) C=C-Doppelbindungen enthalten und vorzugsweise Vinylgruppen sind, während die reaktiven Gruppen des mindestens drei solche Gruppen tragenden Silans oder Polysiloxans gemäß (b) und gegebenenfalls des nicht mehr als zwei solche Gruppen tragenden Silans oder Polysiloxans gemäß (c) Si-H-Gruppen sind.

## Patentansprüche

1. Dielektrisches Elastomer, umfassend eine Folie, die ein fluoriertes Siliconelastomer enthält oder daraus besteht, sowie beidseitig der Folie eine Beschichtung aus einem dehnbaren Elektrodenmaterial, oder bestehend aus diesen Komponenten, **dadurch gekennzeichnet, dass** das fluorierte Siliconelastomer einen E-Modul von maximal 450 kPa besitzt, wobei das fluorierte Siliconelastomer durch die Umsetzung eines langkettigen fluorierten Divinyl(polysiloxan)-Copolymeren mit zwei oder mehr als zwei reaktiven Gruppen mit einem fluorierten silanhaltigen Vernetzer hergestellt worden ist, der drei oder mehr als drei reaktive Gruppen aufweist, oder wobei das fluorierte Siliconelastomer durch die Umsetzung eines langkettigen fluorierten Divinyl(polysiloxan)-Copolymeren mit drei oder mehr als drei reaktiven Gruppen mit einem fluorierten Siloxan hergestellt worden ist, das zwei oder mehr als zwei reaktive Gruppen aufweist, und wobei der Fluorierungsgrad des langkettigen fluorierten Divinyl(polysiloxan)-Copolymers mindestens 10% bevorzugt mindestens 20% und besonders bevorzugt mindestens 40% beträgt, und/oder worin 10, 20 bzw. 40% der Kohlenwasserstoff-Seitengruppen an den Si-Atomen fluoriert sind.

2. Dielektrisches Elastomer nach Anspruch 1, **dadurch gekennzeichnet, dass** das fluorierte Siliconelastomer ein dreidimensional vernetztes fluoriertes, alkylgruppenhaltiges Polysiloxan in Kombination mit einem fluorierten Siliconöl aufweist und/oder dass das fluorierte Siliconelastomer ein dreidimensional weitmaschig vernetztes, fluoriertes, alkylgruppenhaltiges Polysiloxan aufweist, dessen Weitmaschigkeit durch eine Kettenverlängerung durch Addition eines zwei Si-H-Gruppen enthaltenden kettenförmigen Siliconmoleküls an ein Vinylgruppen enthaltendes Polysiloxanmolekül bewirkt wurde.

3. Dielektrisches Elastomer nach Anspruch 2, wobei der Fluorierungsgrad des fluorierten Siliconöls dem des dreidimensional vernetzten, fluorierten, alkylgruppenhaltigen Polysiloxans entspricht oder um maximal ±10% davon abweicht, bezogen auf die Anzahl von fluorierten Alkylgruppen in den jeweiligen Materialien.

4. Dielektrisches Elastomer nach Anspruch 1, worin das langkettige fluorierte Divinyl(polysiloxan)-Copolymer nicht mehr als zwei reaktive Gruppen trägt und der fluorierte silanhaltige Vernetzer nicht mehr als drei reaktive Gruppen trägt, oder worin das langkettige fluorierte Divinyl(polysiloxan)-Copolymer nicht mehr als drei reaktive Gruppen trägt und das fluorierte Siloxan nicht mehr als zwei reaktive Gruppen trägt.

5. Dielektrisches Elastomer nach Anspruch 1, 2 oder 4, wobei das Vinylgruppen enthaltende Polysiloxanmolekül ein langkettiges fluoriertes Divinyl(polysiloxan)-Copolymer mit einem Molekulargewicht von mindestens 10000 g/mol, bevorzugt mindestens 20000 g/mol und besonders bevorzugt mindestens 40000 g/mol ist.

6. Dielektrisches Elastomer nach einem der voranstehenden Ansprüche, wobei das fluorierte Elastomer durch die Vernetzung eines fluorierten Divinyl(polysiloxan)-Copolymers mit Trifluoropropyltris(dimethylsiloxy)silan, ggf. unter Verlängerung der Polymerketten durch Zusatz von Difluoropropylbis(dimethylsiloxy)silan, entstanden ist.

7. Dielektrisches Elastomer nach einem der voranstehenden Ansprüche, wobei der E-Modul des fluorierten Siliconelastomers höchstens 300 kPa, bevorzugt höchstens 200 kPa und besonders bevorzugt höchstens 100 kPa beträgt.

8. Dielektrisches Elastomer nach einem der vorangehenden Ansprüche, **dadurch gekennzeichnet, dass** mindestens auf einer der Beschichtungen aus einem dehnbaren Elektrodenmaterial eine oder mehrere Doppelschicht(en) aufgebracht ist/sind, die aus einer weiteren Schicht aus einem fluorierten Siliconelastomer mit einem E-Modul von maximal 450 kPa und einer weiteren Beschichtung aus einem dehnbaren Elektrodenmaterial besteht, derart, dass jeweils zwei Beschichtungen aus einem dehnbaren Elektrodenmaterial durch eine Schicht aus einem fluorierten Siliconelastomer voneinander getrennt sind und umgekehrt, wobei die Beschichtungen aus einem dehnbaren Elektrodenmaterial alternierend als positive und als negative Elektrode geschaltet werden können oder geschaltet sind.

9. Dielektrisches Elastomer nach einem der voranstehenden Ansprüche, weiterhin umfassend eine Isolationsschicht auf jeder der außenliegenden Beschichtungen aus einem dehnbaren Elektrodenmaterial.

10. Dielektrisches Elastomer nach einem der voranstehenden Ansprüche, worin jede Beschichtung aus einem Elektrodenmaterial mit einer elektrischen Zuleitung kontaktiert ist.

11. Verwendung eines Dielektrischen Elastomers nach Anspruch 10 als Dielektrischer Elastomeraktor, Dielektrischer Elastomersensor oder Dielektrischer Elastomergenerator.

12. Verfahren zum Herstellen eines Dielektrischen Elastomeren wie in einem der Ansprüche 1 bis 7 definiert, umfassend die folgenden Schritte:
(a) Bereitstellen eines zumindest teilweise fluorierten Polysiloxans, das mindestens zwei reaktive Gruppen trägt,
(b) Bereitstellen eines mindestens teilweise fluorierierten Silans oder Polysiloxans, das mindestens drei Gruppen trägt, die mit einer reaktiven Gruppe des zumindest teilweise fluorierten Polysiloxans gemäß (a) reagieren können,
- mit der Maßgabe, dass entweder das mindestens zwei reaktive Gruppen tragende Polysiloxan gemäß (a) oder das mindestens drei reaktionsfähige Gruppen tragende Silan oder Polysiloxan gemäß (b) ein Molekulargewicht von mindestens 10000 g/mol aufweist,
(c) Vermischen des Polysiloxans gemäß (a), des Silans oder Polysiloxans gemäß (b), eines Siliconöls sowie ggf. eines Katalysators,
(d) schichtförmiges Auftragen der gemäß (c) entstandenen Mischung auf einer Unterlage,
(e) Bewirken der Umsetzung der reaktiven Gruppen in der Mischung durch Licht und/oder Wärme und/oder den Zusatz eines Katalysators, unter Ausbilden einer stabilen Folie;
(f) Ablösen der Folie von der Unterlage,
(g) Herstellen einer oder mehrerer Mischungen, umfassend die in (c) genannten Materialien sowie ein elektrisch leitfähiges Pulver,
(h) Auftragen einer Mischung gemäß (g) auf einer Seite der Folie und entweder derselben Mischung oder einer anderen Mischung gemäß (g) auf der anderen Seite der Folie, und
(i) Bewirken der Umsetzung der reaktiven Gruppen in der Mischung durch Licht und/oder Wärme und/oder den Zusatz eines Katalysators.

13. Verfahren zum Herstellen eines Dielektrischen Elastomeren wie in einem der Ansprüche 1 bis 7 definiert, umfassend die folgenden Schritte:
(a) Bereitstellen eines zumindest teilweise fluorierten Polysiloxans, das mindestens zwei reaktive Gruppen trägt,
(b) Bereitstellen eines mindestens teilweise fluorierten Silans oder Polysiloxans, das drei oder mehr als drei Gruppen trägt, die mit einer reaktiven Gruppe des zumindest teilweise fluorierten Polysiloxans gemäß (a) reagieren können,
(c) Bereitstellen eines mindestens teilweise fluorierten Silans oder Polysiloxans, das nicht mehr als zwei Gruppen trägt, die mit einer reaktiven Gruppe des zumindest teilweise fluorierten Polysiloxans gemäß (a) reagieren können,
- mit der Maßgabe, dass mindestens ein Polysiloxan gemäß (a), (b) oder (c) bereitgestellt wird, das ein Molekulargewicht von mindestens 10000g/mol aufweist,
(d) Vermischen des Polysiloxans gemäß (a), des Silans oder Polysiloxans gemäß (b), des Silans oder Polysiloxans gemäß (c) sowie ggf. eines Katalysators,
(e) schichtförmiges Auftragen der gemäß (d) entstandenen Mischung auf einer Unterlage,
(f) Bewirken der Umsetzung der reaktiven Gruppen in der Mischung durch Licht und/oder Wärme und/oder den Zusatz eines Katalysators, unter Ausbilden einer stabilen Folie,
(g) Ablösen der Folie von der Unterlage,
(h) Herstellen einer oder mehrerer Mischungen, umfassend die in (d) genannten Materialien sowie ein elektrisch leitfähiges Pulver,
(i) Auftragen einer Mischung gemäß (h) auf einer Seite der Folie und entweder derselben Mischung oder einer anderen Mischung gemäß (h) auf der anderen Seite der Folie, und
(k) Bewirken der Umsetzung der reaktiven Gruppen in der Mischung durch Licht und/oder Wärme und/oder den Zusatz eines Katalysators.

## Claims

1. A dielectric elastomer comprising a film containing or consisting of a fluorinated silicone elastomer and on both sides of the film a coating of an extensible electrode material or consisting of these components, **characterized in that** the fluorinated silicone elastomer has a modulus of elasticity of at most 450 kPa, wherein the fluorinated silicone elastomer has been prepared by reacting a long-chain fluorinated divinyl(polysiloxane) copolymer having two or more than two reactive groups with a fluorinated silane-containing crosslinking agent containing three or more reactive groups, or wherein the fluorinated silicone elastomer has been prepared by reacting a long-chain fluorinated divinyl(polysiloxane) copolymer having three or more than three reactive groups with a fluorinated siloxane containing two or more than two reactive groups, and wherein the degree of fluorination of the long-chain fluorinated divinyl(polysiloxane) copolymer is at least 10%, preferably at least 20% und particularly preferably at least 40%, and/or wherein 10 or 20 or 40% of the side hydrocarbon groups at the Si atoms are fluorinated.

2. The dielectric elastomer according to claim 1, **characterized in that** the fluorinated silicone elastomer comprises a three-dimensionally crosslinked fluorinated alkyl group-containing polysiloxane in combination with a fluorinated silicone oil and/or in that the fluorinated silicone elastomer comprises a three-dimensionally wide-meshed crosslinked fluorinated alkyl group-containing polysiloxane, the wide mesh of which has been caused by chain extension by addition of a chain-shaped silicone molecule containing two Si-H groups to a vinyl group-containing polysiloxane molecule.

3. The dielectric elastomer according to claim 2, wherein the degree of fluorination of the fluorinated silicone oil corresponds to or differs from that of the three-dimensionally crosslinked fluorinated alkyl group-containing polysiloxane by a maximum of ±10% based on the number of fluorinated alkyl groups in the respective materials.

4. The dielectric elastomer according to claim 1 wherein the long-chain fluorinated divinyl(polysiloxane) copolymer carries no more than two reactive groups and the fluorinated silane-containing crosslinker carries no more than three reactive groups, or wherein the long-chain fluorinated divinyl(polysiloxane) copolymer carries no more than three reactive groups and the fluorinated siloxane carries no more than two reactive groups.

5. The dielectric elastomer according to claim 1, 2 or 4, wherein the vinyl group-containing polysiloxane molecule is a long-chain fluorinated divinyl(polysiloxane) copolymer having a molecular weight of at least 10,000 g/mol, preferably at least 20,000 g/mol and more preferably at least 40,000 g/mol.

6. The dielectric elastomer according to one of the preceding claims, wherein the fluorinated elastomer is formed by crosslinking a fluorinated divinyl(polysiloxane) copolymer with trifluoropropyltris(dimethylsiloxy)silane, optionally with elongation of the polymer chains by addition of difluoropropylbis(dimethylsiloxy)silane.

7. A dielectric elastomer according to any of the preceding claims, wherein the modulus of elasticity of the fluorinated silicone elastomer is not more than 300 kPa, preferably not more than 200 kPa and particularly preferably not more than 100 kPa.

8. The dielectric elastomer according to one of the preceding claims, **characterized in that** one or more double layer(s) consisting of a further layer of a fluorinated silicone elastomer having a modulus of elasticity of at most 450 kPa and a further coating of a stretchable electrode material is/are applied to at least one of the coatings of a stretchable electrode material, such that in each case two coatings of an extensible electrode material are separated from one another by a layer of a fluorinated silicone elastomer and vice versa, wherein the coatings of an extensible electrode material can or are alternately connected as positive and negative electrodes.

9. The dielectric elastomer according to one of the preceding claims, further comprising an insulating layer on each of the outer coatings of an extensible electrode material.

10. The dielectric elastomer according to any of the preceding claims, wherein each coating of an electrode material is contacted with an electrical lead.

11. Use of a dielectric elastomer according to claim 10 as a dielectric elastomer actuator, dielectric elastomer sensor or dielectric elastomer generator.

12. A method for producing a dielectric elastomer as defined in any one of claims 1 to 7, comprising the steps of:
(a) providing an at least partially fluorinated polysiloxane having at least two reactive groups,
(b) providing an at least partially fluorinated silane or polysiloxane having at least three groups capable of reacting with a reactive group of the at least partially fluorinated polysiloxane according to (a),
- with the proviso that either the polysiloxane carrying at least two reactive groups according to (a) or the silane or polysiloxane carrying at least three reactive groups according to (b) has a molecular weight of at least 10,000 g/mol,
(c) mixing the polysiloxane according to (a), the silane or polysiloxane according to (b), a silicone oil and optionally a catalyst,
(d) applying the mixture formed according to (c) in layers on a base,
(e) effecting the conversion of the reactive groups in the mixture by light and/or heat and/or the addition of a catalyst, thereby forming a stable film;
(f) removing the foil from the base,
(g) preparing one or more mixtures comprising the materials mentioned in (c) and an electrically conductive powder,
(h) applying a mixture according to (g) on one side of the film and either the same mixture or another mixture according to (g) on the other side of the film, and
(i) effecting the conversion of the reactive groups in the mixture by light and/or heat and/or the addition of a catalyst.

13. A method for producing a dielectric elastomer as defined in any one of claims 1 to 7, comprising the steps of:
(a) providing an at least partially fluorinated polysiloxane bearing at least two reactive groups,
(b) providing an at least partially fluorinated silane or polysiloxane bearing three or more than three groups capable of reacting with a reactive group of the at least partially fluorinated polysiloxane according to (a),
(c) providing an at least partially fluorinated silane or polysiloxane bearing no more than two groups capable of reacting with a reactive group of the at least partially fluorinated polysiloxane according to (a),
- with the proviso that at least one polysiloxane according to (a), (b) or (c) having a molecular weight of at least 10000g/mol is provided,
(d) mixing the polysiloxane according to (a), the silane or polysiloxane according to (b), the silane or polysiloxane according to (c) and optionally a catalyst,
(e) applying the mixture produced according to (d) in layers on a base,
(f) effecting the conversion of the reactive groups in the mixture by light and/or heat and/or the addition of a catalyst, thereby forming a stable film,
(g) removing the foil from the base,
(h) preparing one or more mixtures comprising the materials mentioned in (d) and an electrically conductive powder,
(i) applying a mixture according to (h) on one side of the film and either the same mixture or another mixture according to (h) on the other side of the film, and
(k) effecting the conversion of the reactive groups in the mixture by light and/or heat and/or the addition of a catalyst.

## Revendications

1. Elastomère diélectrique, comprenant une feuille, qui contient un élastomère silicone fluoré ou en est constituée, ainsi que sur les deux côtés de la feuille un revêtement en un matériau d'électrode extensible, ou se composant de ces composants, **caractérisé en ce que** l'élastomère silicone fluoré a été produit par la réaction d'un copolymère divinyl(polysiloxane) fluoré à longue chaîne présentant deux ou plus de deux groupes réactifs avec un agent réticulant contenant un silane et fluoré, qui présente trois ou plus de trois groupes réactifs, ou dans lequel l'élastomère silicone fluoré a été produit par la réaction d'un copolymère divinyl(polysiloxane) fluoré à longue chaîne présentant trois ou plus de trois groupes réactifs avec un siloxane fluoré, qui présente deux ou plus de deux groupes réactifs, et dans lequel le degré de fluoration du copolymère divinyl(polysiloxane) fluoré à longue chaîne vaut au moins 10 %, de préférence au moins 20 %, et de préférence encore au moins 40 %, et/ou dans lequel 10, 20 ou 40 % des groupes hydrocarbure pendants sont fluorés sur les atomes de Si.

2. Elastomère diélectrique selon la revendication 1, **caractérisé en ce que** l'élastomère silicone fluoré présente un polysiloxane réticulé à trois dimensions, fluoré et contenant des groupes alkyle en combinaison avec une huile de silicone fluorée et/ou **en ce que** l'élastomère silicone fluoré présente un polysiloxane réticulé à grandes mailles en trois dimensions, fluoré et contenant des groupes alkyle, dont la grandeur des mailles a été causée par un prolongement de chaînes par addition d'une molécule de silicone en forme de chaîne contenant deux groupes Si-H à une molécule de polysiloxane contenant des groupes vinyle.

3. Elastomère diélectrique selon la revendication 2, dans lequel le degré de fluoration de l'huile de silicone fluorée correspond à celui du polysiloxane réticulé à trois dimensions, fluoré et contenant des groupes alkyle ou s'en écarte au maximum de ± 10 %, par rapport au nombre de groupes alkyle fluorés dans les matériaux respectifs.

4. Elastomère diélectrique selon la revendication 1, dans lequel le copolymère divinyl(polysiloxane) fluoré à longue chaîne ne porte pas plus de deux groupes réactifs et l'agent réticulant fluoré contenant un silane ne porte pas plus de trois groupes réactifs, ou dans lequel le copolymère divinyl(polysiloxane) fluoré à longue chaîne ne porte pas plus de trois groupes réactifs et le siloxane fluoré ne porte pas plus de deux groupes réactifs.

5. Elastomère diélectrique selon la revendication 1, 2 ou 4, dans lequel la molécule de polysiloxane contenant des groupes vinyle est un copolymère divinyl(polysiloxane) fluoré à longue chaîne présentant un poids moléculaire d'au moins 10000 g/mole, de préférence d'au moins 20000 g/mole, et de préférence encore d'au moins 40000 g/mole.

6. Elastomère diélectrique selon l'une quelconque des revendications précédentes, dans lequel l'élastomère fluoré est apparu par la réticulation d'un copolymère divinyl(polysiloxane) fluoré avec du trifluoropropyl-tris(diméthylsiloxy)silane, le cas échéant avec prolongement des chaînes du polymère par ajout de difluoropropylbis(diméthylsiloxy)silane.

7. Elastomère diélectrique selon l'une quelconque des revendications précédentes, dans lequel le module E de l'élastomère silicone fluoré vaut au plus 300 kPa, de préférence au plus 200 kPa et de préférence encore au plus 100 kPa.

8. Elastomère diélectrique selon l'une quelconque des revendications précédentes, **caractérisé en ce qu'**une ou plusieurs double(s) couche(s) est/sont déposée(s) au moins sur un des revêtements en un matériau d'électrode extensible, couche(s) qui se compose(nt) d'une autre couche en un élastomère silicone fluoré avec un module E de 450 kPa au maximum et d'un autre revêtement en un matériau d'électrode extensible, de telle manière que deux revêtements en un matériau d'électrode extensible soient chaque fois séparés l'un de l'autre par une couche en un élastomère silicone fluoré et inversement, dans lequel les revêtements en un matériau d'électrode extensible peuvent être ou sont connectés en alternance en électrode positive et négative.

9. Elastomère diélectrique selon l'une quelconque des revendications précédentes, comprenant en outre une couche d'isolation sur chacun des revêtements extérieurs en un matériau d'électrode extensible.

10. Elastomère diélectrique selon l'une quelconque des revendications précédentes, dans lequel chaque revêtement en un matériau d'électrode extensible est en contact avec une ligne d'alimentation électrique.

11. Utilisation d'un élastomère diélectrique selon la revendication 10 comme actionneur élastomère diélectrique, capteur élastomère diélectrique ou générateur élastomère diélectrique.

12. Procédé de fabrication d'un élastomère diélectrique tel que défini dans une des revendications 1 à 7, comprenant les étapes suivantes:
(a) préparation d'un polysiloxane au moins partiellement fluoré, qui porte au moins deux groupes réactifs,
(b) préparation d'un silane ou d'un polysiloxane au moins partiellement fluoré, qui porte au moins trois groupes, qui peuvent réagir avec un groupe réactif du polysiloxane au moins partiellement fluoré selon (a),
- avec la condition que soit le polysiloxane portant au moins deux groupes réactifs selon (a) soit le silane ou le polysiloxane portant au moins trois groupes capables de réagir selon (b) présente un poids moléculaire d'au moins 10000 g/mole,
(c) mélange du polysiloxane selon (a), du silane ou du polysiloxane selon (b), d'une huile de silicone ainsi que le cas échéant d'un catalyseur,
(d) dépôt sous forme de couche du mélange formé selon (c) sur un support,
(e) réalisation de la réaction des groupes réactifs dans le mélange par la lumière et/ou la chaleur et/ou l'ajout d'un catalyseur, avec formation d'une feuille stable;
(f) séparation de la feuille du support,
(g) fabrication d'un ou de plusieurs mélange(s), comprenant les matériaux mentionnés en (c) ainsi qu'une poudre électriquement conductrice,
(h) dépôt d'un mélange selon (g) sur un côté de la feuille et soit du même mélange soit d'un autre mélange selon (g) sur l'autre côté de la feuille, et
(i) réalisation de la réaction des groupes réactifs dans le mélange par la lumière et/ou la chaleur et/ou l'ajout d'un catalyseur.

13. Procédé de fabrication d'un élastomère diélectrique tel que défini dans une des revendications 1 à 7, comprenant les étapes suivantes:
(a) préparation d'un polysiloxane au moins partiellement fluoré, qui porte au moins deux groupes réactifs,
(b) préparation d'un silane ou d'un polysiloxane au moins partiellement fluoré, qui porte trois ou plus de trois groupes, qui peuvent réagir avec un groupe réactif du polysiloxane au moins partiellement fluoré selon (a),
(c) préparation d'un silane ou d'un polysiloxane au moins partiellement fluoré, qui ne porte pas plus de deux groupes, qui peuvent réagir avec un groupe réactif du polysiloxane au moins partiellement fluoré selon (a),
- avec la condition que l'on prépare au moins un polysiloxane selon (a), (b) ou (c), qui présente un poids moléculaire d'au moins 10000 g/mole,
(d) mélange du polysiloxane selon (a), du silane ou du polysiloxane selon (b), du silane ou du polysiloxane selon (c) ainsi que le cas échéant d'un catalyseur,
(e) dépôt sous forme de couche du mélange formé selon (d) sur un support,
(f) réalisation de la réaction des groupes réactifs dans le mélange par la lumière et/ou la chaleur et/ou l'ajout d'un catalyseur, avec formation d'une feuille stable;
(g) séparation de la feuille du support,
(h) fabrication d'un ou de plusieurs mélange(s), comprenant les matériaux mentionnés en (d) ainsi qu'une poudre électriquement conductrice,
(i) dépôt d'un mélange selon (h) sur un côté de la feuille et soit du même mélange soit d'un autre mélange selon (h) sur l'autre côté de la feuille, et
(k) réalisation de la réaction des groupes réactifs dans le mélange par la lumière et/ou la chaleur et/ou l'ajout d'un catalyseur.
